# EUROPÄISCHE PATENTSCHRIFT

(11) **EP 3 632 195 B1**
(45) Veröffentlichungstag und Bekanntmachung des Hinweises auf die Patenterteilung: **06.07.2022**
(21) Anmeldenummer: 18713859.9
(22) Anmeldetag: 22.03.2018
(51) Int. Cl.: H05K 7/14, H02K 11/33

(54) **STEUEREINHEIT ZUR ANSTEUERUNG EINER ANTRIEBSVORRICHTUNG, MOTOREINHEIT MIT EINER ANTRIEBSVORRICHTUNG UND EINER STEUEREINHEIT SOWIE VERFAHREN ZUR HERSTELLUNG EINER MOTOREINHEIT**
CONTROL UNIT FOR ACTIVATING A DRIVE DEVICE, MOTOR UNIT HAVING A DRIVE DEVICE AND HAVING A CONTROL UNIT, AND METHOD FOR PRODUCING THE MOTOR UNIT.
UNITÉ DE COMMANDE SERVANT À PILOTER UN DISPOSITIF D'ENTRAÎNEMENT, UNITÉ MOTORISÉE COMPRENANT UN DISPOSITIF D'ENTRAÎNEMENT ET UNE UNITÉ DE COMMANDE, AINSI QUE PROCÉDÉ DE FABRICATION D'UNE UNITÉ MOTORISÉE

(30) Priorität: 24.05.2017 DE 102017208864
(43) Veröffentlichungstag der Anmeldung: 08.04.2020
(73) Patentinhaber: Robert Bosch GmbH, 70442 Stuttgart (DE)
(72) Erfinder: SCHALOWSKI, Gerhard, 72581 Dettingen (DE); WEEBER, Volker, 74348 Lauffen A. N. (DE); SEGIET, Raphael, 72768 Reutlingen (DE)
(86) Internationale Anmeldenummer: PCT/EP2018/057321
(87) Internationale Veröffentlichungsnummer: WO 2018/215120

(56) Entgegenhaltungen:
- EP-A1- 1 523 087
- EP-A2- 2 615 725
- DE-A1- 19 723 664
- US-A1- 2002 047 504

## Beschreibung

### Stand der Technik

Die nicht vorveröffentlichte Patentanmeldung DE 10 2016 212 585 A1 offenbart eine Motorvorrichtung mit einem Elektromotor und einer Steuerelektronik. Die Steuerelektronik ist dazu ausgelegt einen Betrieb des Elektromotors zu steuern. Das Motorgehäuse der Motorvorrichtung ist dabei über eine Klebstoffverbindung am Elektronikgehäuse der Steuerelektronik befestigt. Die Offenlegungsschrift DE 197 23 664 A1 betrifft eine Steuereinheit zur Ansteuerung einer Antriebsvorrichtung. Die Steuereinheit weist eine Leiterplatte auf, die mit wenigstens einem Anschlusselement der Antriebsvorrichtung kontaktierbar ist. Die Druckschrift EP 2 615 725 A2 beschreibt eine weitere Steuereinheit zur Ansteuerung einer Antriebsvorrichtung.

### Offenbarung der Erfindung

Die erfindungsgemäße Steuereinheit zur Ansteuerung einer Antriebsvorrichtung weist eine Leiterplatte auf, welche mit wenigstens einem Anschlusselement der Antriebsvorrichtung zu kontaktieren ist Die Leiterplatte weist wenigstens eine Durchführung auf, durch die das wenigstens eine Anschlusselement hindurch geführt werden kann. Die Leiterplatte weist ferner eine Kontaktierungsseite auf, von der her kommend die Leiterplatte mit dem Anschlusselement kontaktierbar ist. Die Kontaktierungsseite der Leiterplatte ist dabei der Antriebsvorrichtung abgewandt

Die Steuereinheit kann beispielsweise eine Steuereinheit eines Bremskraftverstärkers sein, welcher mittels eines Elektromotors antreibbar ist Der Elektromotor kann

dabei die Antriebsvorrichtung darstellen. Die Antriebsvorrichtung, also der Elektromotor, sowie die zugehörige Steuereinheit, müssen miteinander elektrisch leitend kontaktiert werden. Eine Steuereinheit umfasst in der Regel eine Leiterplatte. Die Leiterplatte der Steuereinheit hat eine Seite welche dem Elektromotor abgewandt ist. Es kann erforderlich sein, die Leiterplatte von der abgewandten Seite her zu kontaktieren. Um dies zu gewährleisten weist die Leiterplatte besagte Öffnung oder auch Durchführung auf, durch die jeweils das wenigstens eine Anschlusselement hindurch geführt werden kann.

Auf diese Weise ist eine rückseitige Kontaktierung der Leiterplatte möglich, auch wenn die Antriebsvorrichtung, also der Motor, von einer Vorderseite der Leiterplatte her verbaut werden soll. In vorteilhafter Weise kann eine Kontaktierung des Motors mit der Steuereinheit dadurch platzsparend und an bauliche Erfordernisse angepasst erfolgen.

Es kann vorteilhaft sein, wenn für jedes Anschlusselement, welches zur Kontaktierung des Motors erforderlich ist auch jeweils eine zugeordnete Durchführung in der Leiterplatte vorgesehen ist Ebenso kann eine Durchführung in der Leiterplatte vorgesehen sein, durch die zwei oder mehrere Anschlusselemente durchgeführt werden können.

In weiterer vorteilhafter Ausgestaltung der Steuereinheit ist die wenigstens eine Durchführung derart ausgelegt, dass das wenigstens eine Anschlusselement von einer Montageseite der Leiterplatte her durch die wenigstens eine Durchführung der Leiterplatte hindurch zur Kontaktierungsseite durchführbar ist Die Montageseite ist dabei der Leiterplatte der Antriebsvorrichtung zugewandt. Dies ermöglicht, dass das wenigstens eine Anschlusselement, welches mit der Leiterplatte in Verbindung zu bringen ist, von einer Seite der Leiterplatte auf die andere Seite der Leiterplatte gelangen kann.

In erfindungsgemäßer Ausgestaltung der Steuereinheit weist diese ferner wenigstens ein Umlenkmittel auf. Das Umlenkmittel ist dabei auf der Kontaktierungsseite der Leiterplatte in der Steuereinheit angeordnet. Somit befindet sich das Umlenkmittel auf derjenigen Seite der Leiterplatte, welche der Antriebsvorrichtung abgewandt ist. Je nach vorgesehener Anzahl an Anschlusselementen kann eine entsprechende Anzahl an Umlenkmitteln in der Steuereinheit vorgesehen sein.

Erfindungsgemäß ist das Umlenkmittel dabei einerseits - beispielsweise an einem ersten Ende - mit der Leiterplatte von deren Kontaktierungsseite her kontaktierbar, sowie andererseits - beispielsweise an einem anderen Ende - mit dem wenigstens einen Anschlusselement der Antriebsvorrichtung. Unter einem Umlenkmittel kann ein elektrisch leitendes Bauteil verstanden werden, welches in der Steuereinheit verbaut und/oder angeordnet ist Solche Bauteile können Pins, oder Stanzteile sein, aus Metall oder Blech, die in geeigneter Weise einteilig, oder mehrteilig verbunden ein Um-An einem Bereich - insbesondere an einem Ende - des wenigstens einen Umlenkmittels ist dieses elektrisch leitend mit der Leiterplatte verbunden, an einem zweiten Bereich - beispielsweise an einem anderen Ende - des Umlenkmittels kann dieses mit dem Anschlusselement verbunden werden, wenn dieses durch die Öffnung in der Leiterplatte geführt wird. Das Umlenkmittel erlaubt eine elektrische Verbindung zwischen einem zugeordneten Anschlusselement und der Leiterplatte, wobei die elektrische Verbindung eine Umlenkung aus einer Vorzugsrichtung des Anschlusselements in Bezug auf die Leiterplatte erfährt.

In erfindungsgemäßer Ausgestaltung weist das Gehäuse der Steuereinheit eine Aufnahme für das wenigstens eine Umlenkmittel auf. Erfindungsgemäß weist die Unterseite des Gehäuses der Steuereinheit dabei die Aufnahme für das Umlenkmittel auf. Auf diese Weise ist das Umlenkmittel, beispielsweise umfassend elektrisch leitende Pins oder Kontaktstücke, in der Unterseite des Gehäuses gelagert und/oder gestützt. Da bei einer elektrischen Kontaktierung des Umlenkmittels mit dem Anschlusselement Kräfte bei der Montage aufgebracht werden, ist es vorteilhaft das Umlenkmittel stabil in dem Gehäuse der Steuereinheit zu lagern und dort auch abzustützen. So kann das Gehäuse zu hohe Kräfte bei der Montage abstützen und Schäden bei der Montage können vermieden werden.

Ferner ist vorteilhaft, dass das wenigstens eine Umlenkmittel einen eigenen Kontaktierungsbereich aufweist, welcher für die Kontaktierung des wenigstens einen Anschlusselements ausgelegt ist Die wenigstens eine Aufnahme für das wenigstens eine Umlenkmittel umfasst ferner eine Kontaktierungsaufnahme, welche den Kontaktierungsbereich des Umlenkmittels aufnimmt. Dies ermöglicht eine genauere Positionierung des Kontaktierungsbereichs des Umlenkmittels in der Kontaktierungsaufnahme.

Es ist ferner vorteilhaft, dass das wenigstens eine Anschlusselement ebenfalls im Bereich der Kontaktierungsaufnahme des Gehäuses zumindest anteilig aufgenommen werden kann. Auch dies ermöglicht eine exakte Positionierung des Anschlusselements im Gehäuse der Steuereinheit.

Vorteilhaft ist ferner, dass die Kontaktierung des Kontaktierungsbereiches der Umlenkmittel mit dem wenigstens einen Anschlusselement im Bereich der Kontaktierungsaufnahme erfolgt.

Die Kontaktierung erfolgt in vorteilhafter Ausgestaltung der Erfindung durch ein Aufpressen des wenigstens einen Anschlusselements auf den Kontaktierungsbereich des Umlenkmittels im Bereich der Kontaktierungsaufnahme. Durch das Aufpressen entsteht eine stabile und gut elektrisch leitbare Verbindung zwischen Anschlusselement und dem Umlenkmittel. Dies erhöht in vorteilhafter Weise die Stabilität der Verbindung und die elektrische Kontaktierung. Das Aufpressen des Anschlusselements auf den Kontaktierungsbereich des Umlenkmittels in der Kontaktaufnahme kann auch als Steckverbindung verstanden werden.

Das wenigstens eine Anschlusselement des Elektromotors wird durch wenigstens eine Gehäuseöffnung in das Innere des Gehäuses der Steuereinheit eingeführt. Die Gehäuseöffnung befindet sich dabei auf der Montageseite der Leiterplatte. Auf diese Weise kann das wenigstens eine Anschlusselement des Motors in das Gehäuseinnere gelangen, bevor es von der Montageseite der Leiterplatte her kommend, durch die Öffnung, oder auch Durchführung der Leiterplatte hindurch auf die Kontaktierungsseite der Leiterplatte zu dem Umlenkmittel gelangt.

Eine erfindungsgemäße Motoreinheit umfasst eine Antriebsvorrichtung sowie eine Steuereinheit, welche erfindungsgemäß eine Leiterplatte aufweist, die wie beschrieben kontaktierbar ist.

Ferner umfasst die Erfindung ein Verfahren zur Herstellung einer Motoreinheit, welche eine Steuereinheit und eine Antriebsvorrichtung umfasst. Die Steuereinheit weist dabei eine, mit wenigstens einem Anschlusselement der Antriebsvorrichtung zu kontaktierende Leiterplatte auf. Die Leiterplatte weist wenigstens eine Durchführung für das wenigstens eine Anschlusselement auf.

Das Herstellungsverfahren umfasst ein Kontaktieren der Leiterplatte mit der Antriebsvorrichtung über das wenigstens eine Anschlusselement von einer Kontaktierungsseite der Leiterplatte her. Dabei ist die Kontaktierungsseite der Antriebsvorrichtung abgewandt. Das Anschlusselement wird dabei durch die wenigstens eine Durchführung der Leiterplatte geführt.

In Ausgestaltung des Herstellungsverfahrens erfolgt das Führen des wenigstens einen Anschlusselements durch die Durchführung der Leiterplatte über ein aufeinander Zuführen der Antriebsvorrichtung auf die Steuereinheit. Da in der Regel das Anschlusselement fest mit der Antriebsvorrichtung, also mit dem Motor, verbunden ist kann durch ein aufeinander Zuführen, also ein Positionieren des Motors in Bezug auf die Steuereinheit, das Anschlusselement durch die Durchführung durchgeführt werden. Dies ermöglicht ein einfaches Montieren der Bauteile in Bezug zueinander.

Das Anschlusselement kann in Ausgestaltung des erfindungsgemäßen Herstellungsverfahrens durch eine wenigstens eine zugeordnete Öffnung im Gehäuse der Steuereinheit in das Innere des Gehäuses eingeführt werden. Die Öffnung kann dabei in einer Oberseite des Gehäuses vorliegen, welche auf eine Gehäuseunterseite des Gehäuses aufgesetzt ist. Auf diese Weise kann der Motor auf ein bereits verschlossenes Steuergerät, mit verbundener Ober- und Unterseite aufgesetzt werden. Durch das Aufsetzen gelangt das wenigstens eine Anschlusselement durch das Gehäuse in das Innere der Steuereinheit, wobei ferner das Anschlusselement durch die Leiterplatte hindurch greift und dort - wie bereits beschrieben - über das Umlenkmittel mittels der Leiterplatte kontaktiert wird.

In Ausgestaltung des Herstellungsverfahrens ist die Leiterplatte im Gehäuse der Steuereinheit aufgenommen, insbesondere in einem Unterteil des Gehäuses. Dies hat zum Vorteil, dass die Leiterplatte an der richtigen Stelle positioniert ist, sodass das Anschlusselement durch die in der Leiterplatte vorgesehene wenigstens eine Öffnung beziehungsweise Durchführung bei der Montage hindurch gelangen kann.
Figur 1 zeigt eine Antriebsvorrichtung umfassend eine Steuereinheit sowie einen Teil einer Antriebseinheit.
Figur 2 zeigt einen Querschnitt durch die Steuereinheit.
Figur 3 zeigt ebenfalls einen Querschnitt durch die Steuereinheit mit Details der elektrischen Kontaktierung.
Figur 4 zeigt Details der elektrischen Kontaktierung in der Steuereinheit.
Figur 5 zeigt ebenfalls Details der elektrischen Kontaktierung in der Steuereinheit.
Figur 6 zeigt ein Ablaufdiagramm eines Herstellungsverfahrens eine Motorvorrichtung,

Im Folgenden werden Ausführungsformen der Erfindung anhand der Figuren beschrieben.

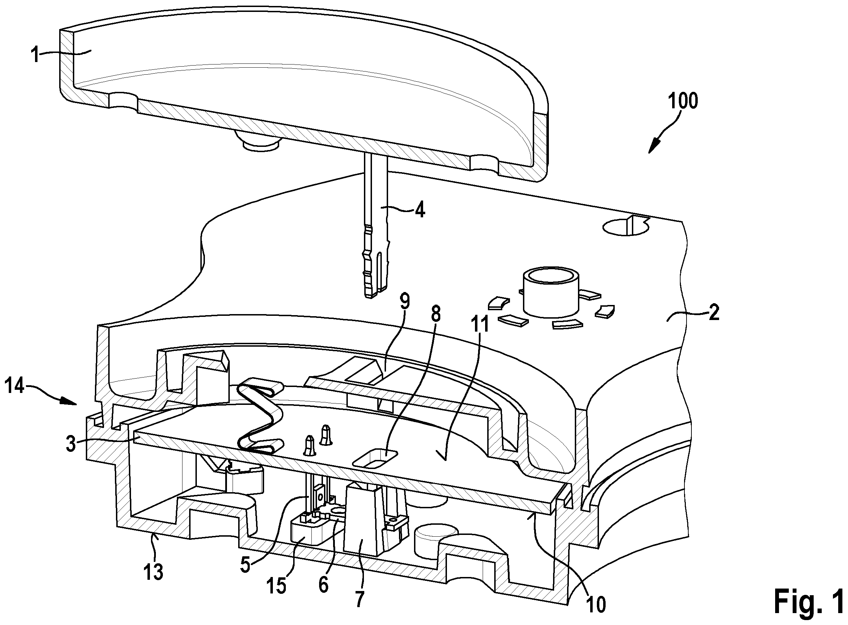

Figur 1 zeigt eine Motoreinrichtung 100. Die Motoreinrichtung 100 kann aus einem Steuergerät 2 sowie einer Antriebsvorrichtung 1 bestehen. Die Steuereinheit 2 umfasst eine Leiterplatte 3. Die Leiterplatte 3 kann beispielsweise ein Schaltungsträger sein, der elektrische Schaltungen aufweist, welche zur Ansteuerung des Motors 1 verwendet werden. Die Leiterplatte 3 ist im Inneren eines Gehäuses 14 der Steuereinheit 2 aufgenommen. In den Figuren ist nur ein Teil der Antriebsvorrichtung 1 gezeigt, insbesondere ein Gehäuse der Antriebsvorrichtung 1.

Die Leiterplatte 3 weist eine Oberseite 11 sowie eine Unterseite 10 auf. Die Oberseite 11 kann dabei eine Seite der Leiterplatte 3 sein, welche dem Motor 1 zugewandt ist. Die Unterseite 10 ist dem Motor 1 abgewandt.

Es ist vorgesehen, den Motor 1 elektrisch mit der Leiterplatte 3 zu kontaktieren.

Eine elektrische Kontaktierung des Motors 1 mit der Leiterplatte 3 soll von der Unterseite 10 der Leiterplatte 3 her erfolgen.

Im Folgenden wird erläutert, wie eine Kontaktierung des Motors 1 mit der Leiterplatte 3 von der Unterseite 10 her erfolgen kann.

Beim Zusammenbauen der Motoreinheit 100 wird in der Regel eine Antriebseinheit 1 - also ein Motor 1 - der Steuereinheit 2 zugeführt. Ebenso kann selbstverständlich die Steuereinheit 2 auch auf die Antriebseinheit 1 zubewegt werden. Antriebseinheit 1 sowie Steuereinheit 2 können in bekannter Weise durch unterschiedliche Befestigungsmaßnahmen miteinander verbunden werden. So ist beispielsweise ein Verkleben, ein Verschrauben oder auch ein Verschweißen von Gehäusen der Antriebsvorrichtung 1 und der Steuereinheit 2 denkbar.

Die Antriebseinheit 1 weist einen Anschlusskontakt 4 auf . Der Anschlusskontakt 4 kann auch als Anschlusselement 4 verstanden werden. Beim aufeinander zubewegen von Antriebseinheit 1 und Steuereinheit 2 kann der Anschlusskontakt 4 in das Innere der Steuereinheit 2 eingeführt werden. Das Einführen des Anschlusskontakts 4 in das Innere der Steuereinheit 2 kann durch eine Öffnung 9 im Gehäuse 14 der Steuereinheit 2 erfolgen. Die Öffnung kann dabei beispielsweise in einem Deckel des Gehäuses 14 vorgesehen sein.

Im Folgenden wird das Ausführungsbeispiel unter Beschreibung einer Kontaktierung eines einzelnen Anschlusselements 4 beschrieben, welches durch eine Öffnung im Deckel des Gehäuses 14 vorgesehen ist. Es ist aber klar, dass bei Zusammenbau der Motoreinheit 100 auch mehrere Anschlusselemente 4 verwendet werden können, die jeweils mit der Leiterplatte 3 zu kontaktieren sind. Dazu können dann natürlich mehrere Öffnungen 9 im Gehäuse verwendet werden, wobei diese jeweils für die Anschlusselemente 4 vorhanden sind. Dabei kann eine eins zu eins Zuordnung zwischen Anschlusselement 4 und Öffnung 9 vorgesehen sein. Ebenso können auch mehrere Anschlusselemente 4 über eine gemeinsame Öffnung 9 in das Innere des Gehäuses gelangen.

Im Inneren des Gehäuses 14 der Steuereinheit 2 befindet sich das Anschlusselement 4 bei einer Montage erst oberhalb der Oberseite 11 der Leiterplatte 3. Die Leiterplatte 3 weist ferner eine Öffnung 8, oder auch Durchführung 8 auf, durch die das Anschlusselement 4 des Motors 1 durchgeführt werden kann. Durch die Durchführung 8 kann das Anschlusselement 4 von der Oberseite 11 zur Unterseite 10 der Leiterplatte 3 durchgeführt werden. Auf diese Weise gelangt das Anschlusselement 4 des Motors 1 unter die Leiterplatte 3. Zur elektrischen Kontaktierung des Anschlusselements 4 mit der Leiterplatte 3 von unten kommend, also von der Unterseite 10 der Leiterplatte 3 her kommend, wird das Anschlusselement 4 über eine elektrisch leitende Verbindung 5, 6 mit der Leiterplatte 3 kontaktiert.

Auch bei den Durchführungen 8 ist klar, dass in der Leiterplatte 3 mehrere Durchführungen 8 vorgesehen sein können, durch die das jeweilige Anschlusselement 4 hindurchgeführt werden kann. Ebenso ist es möglich dass mehrere Anschlusselemente 4 durch eine gemeinsame Durchführung geführt werden.

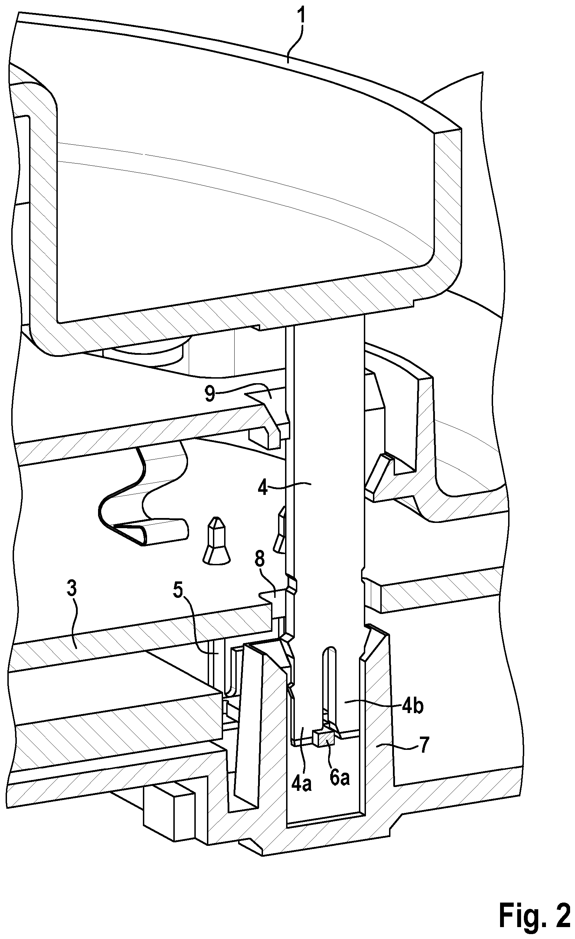

In Figur 1 besteht diese elektrisch leitende Verbindung aus einem elektrisch leitenden Kontaktelement 6, welches im Wesentlichen parallel zur Leiterplatte 3 innerhalb des Gehäuses 14 verläuft. Das Kontaktelement 6 kann in einem Kontaktbereich 6a (siehe Figur 2) des Kontaktelements 6 das Anschlusselement 4 kontaktieren.

Klar ist, dass für den Fall mehrerer Anschlusselemente 4 auch dementsprechend mehrere Kontaktelemente 6 vorgesehen sein können.

An einem weiteren Abschnitt - in Figur 1 am Ende - des Kontaktelements 6 ist ein Pin 5 elektrisch leitend angebunden. Das Kontaktelement 6 kann mit dem Pin 5 derart verbunden werden, dass das Kontaktelement 6 in den Pin 5 eingesteckt und dort punktgeschweißt ist.

Über den Pin 5, der mittels des Kontaktelements 6 auch mit dem Anschlusselement 4 elektrisch leitend verbunden ist, wird das Anschlusselement 4 mit der Leiterplatte 3 verbunden. Der Pin 5 kann in bekannter Weise in die Leiterplatte 3 eingepresst sein.

Bei mehreren Anschlusselementen 4 und mehreren Kontaktelementen 6 können dementsprechend mehrere Pins 5 vorgesehen sein, die die Leiterplatte 3 an unterschiedlichen Stellen kontaktieren.

Das Gehäuse 14 der Steuereinheit 2 weist eine Unterseite 13 auf. Die Unterseite 13 weist wenigstens eine Aufnahme 15, 7 auf welche den Pin 5, dass Kontaktelement 6 sowie das Anschlusselement 4 aufnimmt.

Bei mehreren Anschlusselementen 4 und mehreren Kontaktelementen 6 sowie Pins 5 können entsprechend mehrere Aufnahmen 15,7 vorgesehen sein.

In Figur 1 sind beispielsweise zwei unterschiedliche Aufnahmen eingezeichnet, zum einen eine Aufnahme 15 für den Pin 5, sowie eine Aufnahme 7 für das Kontaktelement 6. Die Aufnahmen 15,7 sind dazu geeignet, die jeweiligen Bauteile zu halten oder auch zu fixieren. Ferner sind die Aufnahmen 15,7 auch dazu geeignet, Kräfte aufzunehmen, oder Kräfte abzustützen. Der Pin 5 kann beispielsweise fest mit der Aufnahme 15 verbunden sein. Das Kontaktelement 6 kann insbesondere in seinem vorderen Bereich, in einer entsprechenden Aufnahme 7 gelagert sein. Da zur elektrischen Kontaktierung des Anschlusselements 4 mit dem Kontaktelement 6 das Anschlusselement 4 auf das Kontaktelement aufgepresst werden muss, benötigt das Kontaktelement 6 eine Kraftabstützung in Montagerichtung des Anschlusselements 4. Details dazu werden in den weiteren Figuren gezeigt.

Die Aufnahme 7 kann ferner dazu geeignet sein, das Anschlusselement 4 seitlich zu führen, wenn dieses auf das Kontaktelement 6 zubewegt wird. Ebenso ist es möglich, dass die Öffnung 9 im Gehäuse 14 der Steuereinheit 2 eine seitliche Führung für das Anschlusselement 4 bei der Montage gewährleistet. So kann das Anschlusselement 4 in richtiger Ausrichtung bei der Montage durch die Öffnung 9 und Durchführung 8 auf die Unterseite 10 der Leiterplatte 3 gelangen, wo das Anschlusselement 4 mit dem Kontaktelement 6 kontaktiert wird. Über das Kontaktelement 6 sowie den Pin 5 gelangt das Anschlusselement in elektrisch leitenden Kontakt mit der Leiterplatte 3.

Figur 2 zeigt eine andere Ansicht der Motoreinrichtung 100. Dabei ist das Anschlusselement 4 bereits weiter in den Innenraum des Gehäuses 14 der Steuereinheit 2 eingeführt. Wie zu erkennen ist, greift das Anschlusselement 4 bereits durch die Öffnung 9 des Gehäuses 14 sowie durch die Durchführung 8 der Leiterplatte 3 hindurch.

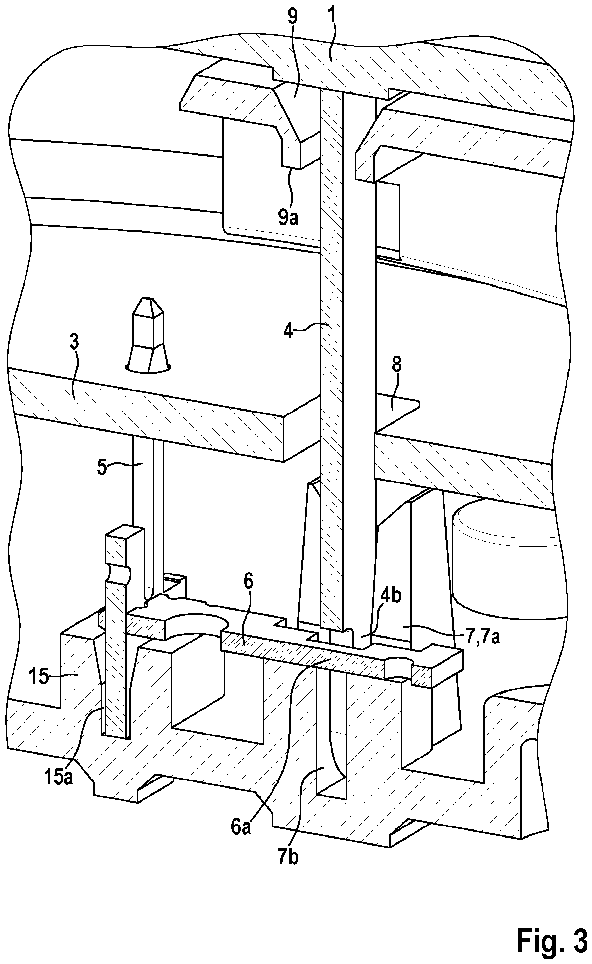

Auch in Figur 2 ist nur ein einzelnes Anschlusselement 4 dargestellt. Ausführungen mit mehreren Anschlusselementen 4 in analoger Kontaktierung sind selbstverständlich möglich. Gleiches gilt für die weiter unten beschriebenen Figuren 3 - 5.

Das Anschlusselement 4 ist in die Aufnahme 7 zumindest anteilig aufgenommen. Im hinteren Bereich des Gehäuses ist der Pin 5 zu erkennen, welcher mit der Leiterplatte 3 elektrisch leitende verbunden ist. Der Pin 5 ist ferner über das Kontaktelement 6 mit dem Anschlusselement 4 verbunden.

Wie bereits erwähnt weist das Kontaktelement 6 einen Kontaktbereich 6a auf. Dieser Kontaktbereich 6a wird zwischen zwei Schenkel 4a und 4a des Anschlusselements 4 aufgenommen. Anders gesagt kann das Anschlusselement 4 beim Verbauen der Motoreinheit 100 auf das Kontaktelement 6 aufgeschoben oder aufgepresst werden. Bei diesem Aufschieben gelangen die Schenkel 4a, 4b des Anschlusselements 4 jeweils auf eine Seite des Kontaktelements 6 im Kontaktbereich 6a.

Figur 3 zeigt eine weitere Schnittdarstellung eines Ausschnitts der Motoreinheit 100, in der das Anschlusselement 4 mit dem Kontaktelement 6 verbunden ist, welches wiederum mit dem Pin 5 und so auch mit der Leiterplatte 3 elektrisch leitend kontaktiert ist.

In dieser Darstellung ist zu erkennen, dass das Anschlusselement durch die Öffnung 9 des Gehäuses 14 der Steuereinheit 2 eingeführt ist. Die Seiten 9a der Öffnung 9 führen dabei das Anschlusselement 4. Ebenso ist zu erkennen wie das Anschlusselement 4 durch die Durchführung 8 der Leiterplatte 3 hindurchragt. In dieser Schnittdarstellung ist ferner die Aufnahme 7 deutlicher gezeigt.

Die Aufnahme 7 umfasst eine Tasche 7B, in welche das Anschlusselement 4 beim Verbauen eintaucht. Ferner umfasst die Aufnahme 7 zwei seitliche Führungen 7A um das Anschlusselement 4 seitlich zu stabilisieren.

Optional kann an dem gezeigten Schenkel 4b eine Ausnehmung vorgesehen sein, welche mit dem Kontaktelement 6 im Kontaktbereich 6a in Eingriff gelangen kann, um die elektrische Kontaktierung zwischen dem Kontaktelement 6 und dem Anschlusselement 4 herzustellen.

Die Aufnahme 15 für den Pin 5 weist ebenfalls eine Tasche 15a auf, welche den Pin 5 stabilisiert.

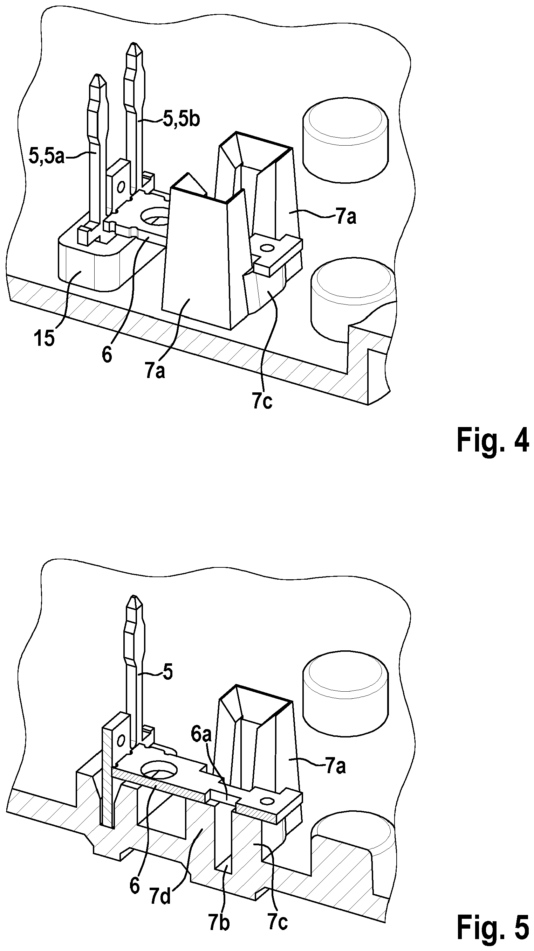

Figuren 4 und 5 zeigen Ausschnitte der Steuereinheit 2 der Motoreinheit 100. Die Ausschnitte der Figuren 4 und 5 zeigen keine Leiterplatte 3 um die Details der Aufnahmen 7,15 nochmals deutlicher hervorzuheben.

Figur 4 zeigt die Seitenführungen 7a für das Anschlusselement 4. Ferner ist zu erkennen, dass die Aufnahme 7 auch noch eine Auflage 7c aufweist, auf der das Kontaktelement 6 aufliegt. Des Weiteren ist zu erkennen, wie der Pin 5 in der Aufnahme 15 für den Pin 5 fixiert ist. Die Tasche 15a sowie die Tasche 7b der jeweiligen Aufnahmen 15,7 sind in dieser Darstellung nicht zu erkennen.

Figur 5 zeigt wiederum einen Schnitt in dem Details der Aufnahme 7 gezeigt sind. Die seitlichen Führungen 7a für das Anschlusselement 4 sind zu erkennen, genauso wie die Auflage 7c für das Kontaktelement 6 und die Tasche 7b welche das Anschlusselement 4 aufnimmt. Im Bereich der seitlichen Führung 7a und der der Tasche 7b befindet sich der Kontaktierbereich 6a des Kontaktelements 6. An dieser Stelle müssen die Schenkel 4a und 4b des Anschlusselements 4 den Kontaktierbereich 6a des Kontaktelements 6 umgreifen können. In Figur 5 ist ferner zu erkennen, dass eine Auflage 7d vorhanden ist, welche ebenfalls das Kontaktelement 6 in Form einer Ablage aufnehmen kann. Die Ablagen 7c und 7d der Aufnahme 7 gewährleisten eine stabile Abstützung des Kontaktelements 6, wenn dieses mit dem Anschlusselement 4 durch Einpressen kontaktiert wird.

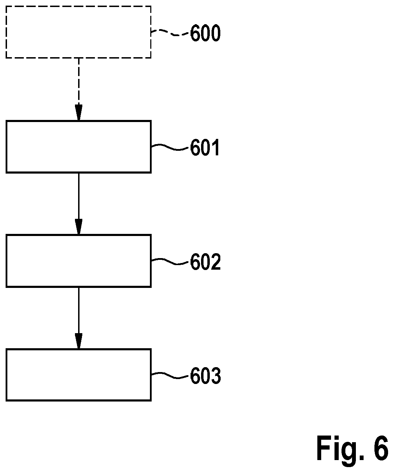

Figur 6 offenbart ein Herstellungsverfahren für eine Motoreinheit 100. Es wird davon ausgegangen, dass die Unterseite 13 des Gehäuses 14 der Steuereinheit 2 für eine Montage bereitgestellt ist.

In der Unterseite 13 des Gehäuses 14 sind bereits der Pin 5 sowie das Kontaktelement 6 eingebracht. Dies kann - wie oben beschrieben - über entsprechende Aufnahmen 7,15 im Gehäuse 14, insbesondere im Gehäuseunterteil 13 des Gehäuses 14 erfolgen. Wie bereits geschildert können Pin 5 und Kontaktelement 6 auch einteilig als Kombi-Pin 5,6 eingefügt sein. Das Einfügen des Pins 5 und des Kontaktelements 6 kann auch in einem Vorabschritt 600 des Herstellungsverfahrens erfolgen.

In einem Schritt 601 des Herstellungsverfahrens wird die Leiterplatte 3 eingesetzt in die Unterseite 13 des Gehäuses 14 eingesetzt. Beim Einsetzen wird ein Ende des Pins 5 in die entsprechende Öffnung der Leiterplatte 3 eingepresst. Auf diese Weise wird der Pin 5 mit elektrischen Bauteilen der Leiterplatte 3 leitend verbunden.

In einem Schritt 602 wird das Gehäuse 14 geschlossen. Dabei wird eine entsprechende Oberseite auf die Unterseite 13 des Gehäuses 14 aufgesetzt und in geeigneter Weise mit der Unterseite 13 verbunden.

In einem Schritt 603 wird nun die Antriebsvorrichtung 1, also der Elektromotor 1 - auf das Gehäuse 14 der Steuereinheit 1 aufgesetzt. Beim Aufsetzen des Motors 1 auf die Steuereinheit 2 wird das wenigstens eine Anschlusselement 4 in das Innere des Gehäuses 14 eingebracht. Dies erfolgt - wie bereits beschrieben - durch die Öffnung 9 des Gehäuses 14. Beim Einbringen des Anschlusselements 4 in das Gehäuse 14 wird das Anschlusselement 4 durch eine Durchführung 8 in der Leiterplatte 3 durchgeführt. Somit gelangt das Anschlusselement 4 von einer der Antriebsvorrichtung 1 zugewandten Seite der Leiterplatte 3 auf eine der Antriebsvorrichtung 1 abgewandte Seite der Leiterplatte 3.

Das Anschlusselement 4 wird unterhalb der Leiterplatte 3 durch Führungen 7a in der Unterseite 13 des Gehäuses 14 aufgenommen. Durch die Führungen 7a geführt gleitet bei der Montage des Motors 1 an der Steuereinheit 2 das Anschlusselement 4 in Richtung des Kontaktierbereichs 6a des Kontaktelements 6.

Durch Aufbringen einer Kraft in Montagerichtung gelangen die Schenkel 4a und 4b des Anschluss Elements 4 seitlich um den Kontaktierbereich 6a. Dabei werden die Schenkel 4a und 4b plastisch verformt, um sich der Breite des Kontaktierbereichs 6a anzupassen. Die verbleibende elastische Spannung in den Schenkeln 4a und 4b erzeugt eine bleibende Kontaktierkraft zwischen den Schenkeln 4a und 4b und dem Kontaktierbereich 6a. Unter einer plastischen Verformung kann ein nach außen biegen der Schenkel 4a und 4b verstanden werden.

Aufgrund der Auslegung und Führung des Anschlusselements 4 beim Verbau , sowie auf Grund der elektrischen Verbindung von Anschlusselement 4 über das Kontaktelement 6 und den Pin 5 zur Leiterplatte 3 ist eine Kontaktierung des Anschlusselements 4 von der Unterseite 10 her an der Leiterplatte 3 möglich.

Die elektrische Verbindung über das Kontaktelement 6 und den Pin 5 erfolgt über zwei Spitzen 5a, 5b des Pins 5. Diese Pinspitzen 5a, 5b sind beispielsweise in Figur 4 gezeigt. Durch Verwendung zweier Pinspitzen 5a und 5b kann die Stromtragfähigkeit erhöht werden. Der Querschnitt eines Pins 5 zur Kontaktierung sollte in einem gewissen Verhältnis zur Dicke der zu kontaktierenden Leiterplatte stehen. Geht man von einer Dicke der Leiterplatte aus, beispielsweise von ca. 1,6 mm, so kann ein einzelner Pin 5 nicht beliebig groß werden. Es könnten jedoch nicht nur zwei Pinspitzen 5a und 5b verwendet werden, sondern auch drei oder mehr Pinspitzen parallel.

Die bei der Montage aufzubringenden Kräfte werden durch entsprechende Gegenelemente, also beispielsweise durch Auflagen 7d und 7c für das Kontaktelement 6 aufgenommen und verhindern so ein Verbiegen des Kontaktelements 6 bei der Montage.

Auch beim Herstellungsverfahren können selbstverständlich mehrere Anschlusselemente 4 zur Anwendung kommen und entsprechend an der Kontaktierung der Leiterplatte beteiligt sein.

Die Ausführungsformen der Figuren wurden anhand eines Anschlusselements beschrieben, welches über ein Kontaktelement mit einer entsprechenden Stelle der Leiterplatte zu verbinden ist. Je nach Anzahl der zu kontaktierenden Anschlüsse des Motors, kann die Steuereinheit mehrfache Kontaktierungsmöglichkeiten für eine entsprechende Anzahl an Anschlusselementen des Motors aufweisen. So können zur Ansteuerung eines dreiphasigen Motors beispielsweise drei Anschlusselemente vorgesehen sein, die - wie bei den beschriebenen Ausführungsformen dargelegt - an 3 Stellen der Leiterplatte kontaktiert werden.

## Patentansprüche

1. Steuereinheit (2) zur Ansteuerung einer Antriebsvorrichtung (1)
- wobei die Steuereinheit (2) eine mit wenigstens einem Anschlusselement (4) der Antriebsvorrichtung (1) zu kontaktierende Leiterplatte (3) aufweist,
- wobei die Leiterplatte (3) wenigstens eine Durchführung (8) für das wenigstens eine Anschlusselement (4) aufweist,
und wobei die Leiterplatte (3) von einer Kontaktierungsseite (10) her über das wenigstens eine Anschlusselement (4) mit der Antriebsvorrichtung (1) kontaktierbar ist, wobei die Kontaktierungsseite (10) der Antriebsvorrichtung (1) abgewandt ist, und wobei die Steuereinheit (2) wenigstens ein Umlenkmittel (5, 6) aufweist, das auf der Kontaktierungsseite (10) der Leiterplatte (3) in der Steuereinheit (2) angeordnet ist, wobei das Umlenkmittel (5,6) einerseits mit der Leiterplatte (3) von der Kontaktierungsseite (10) her sowie andererseits mit dem wenigstens einen Anschlusselement (4) der Antriebsvorrichtung (1) kontaktierbar ist, **dadurch gekennzeichnet, dass** eine Unterseite (13) eines Gehäuses (14) der Steuereinheit (2) wenigstens eine Aufnahme (7,15) für das wenigstens eine Umlenkmittel (5,6) aufweist, so dass das Umlenkmittel (5,6) in der Unterseite (13) des Gehäuses (14) gelagert und/oder gestützt ist.

2. Steuereinheit (2) nach Anspruch 1, **dadurch gekennzeichnet, dass** die wenigstens eine Durchführung (8) derart ausgelegt ist, dass das wenigstens eine Anschlusselement (4) von einer Montageseite (11) der Leiterplatte (3) her durch die wenigstens eine Durchführung (8) zur Kontaktierungsseite (10) durchführbar ist, wobei insbesondere die Montageseite (11) der Leiterplatte (3) der Antriebsvorrichtung (1) zugewandt ist.

3. Steuereinheit (2) nach einem der vorhergehenden Ansprüche, wobei das wenigstens eine Umlenkmittel (5,6) einen Kontaktierungsbereich (6a) zur Kontaktierung des wenigstens einen Anschlusselements (4) aufweist, wobei die wenigstens eine Aufnahme (15, 7) eine Kontaktierungsaufnahme (7) aufweist, in die der Kontaktierungsbereich (6a) aufgenommen ist.

4. Steuereinheit nach Anspruch 3, **dadurch gekennzeichnet, dass** das wenigstens eine Anschlusselement (4) zumindest anteilig in die Kontaktierungsaufnahme (7) aufnehmbar ist.

5. Steuereinheit nach Anspruch 4, **dadurch gekennzeichnet, dass** die Kontaktierung des Kontaktierungsbereichs (6a) des wenigstens einen Umlenkmittels (5,6) mit dem wenigstens einen Anschlusselement (4) in der Kontaktierungsaufnahme (7) herstellbar ist.

6. Steuereinheit nach Anspruch 5, **dadurch gekennzeichnet, dass** die Kontaktierung durch Aufpressen des wenigstens einen Anschlusselements (4) auf den Kontaktierungsbereich (6a) in der Kontaktierungsaufnahme (7) herstellbar ist.

7. Steuereinheit (2) nach einem der vorhergehenden Ansprüche, **dadurch gekennzeichnet, dass** das wenigstens eine zu kontaktierende Anschlusselement (4) durch eine jeweils dem wenigstens einen Anschlusselement (4) zugeordnete Gehäuseöffnung (9) eines Gehäuses (14) der Steuereinheit (2) führbar ist, insbesondere durch eine Gehäuseöffnung (9) die einer Montageseite (11) der Leiterplatte (3) zugewandt ist.

8. Motoreinheit (100) mit einer Antriebsvorrichtung (1) und einer Steuereinheit (2) nach einem der vorhergehenden Ansprüche, wobei die Antriebsvorrichtung (1) wenigstens ein Anschlusselement (4) aufweist, welches mit einer Leiterplatte (3) der Steuereinheit (2) nach einem der vorhergehenden Ansprüche kontaktiert ist.

9. Verfahren zur Herstellung einer Motoreinheit (100) welche eine Steuereinheit (2) und eine Antriebsvorrichtung (1) umfasst, wobei die Steuereinheit (2) eine mit wenigstens einem Anschlusselement (4) der Antriebsvorrichtung (1) zu kontaktierende Leiterplatte (3) aufweist, und wobei die Leiterplatte (3) wenigstens eine dem wenigstens einen Anschlusselement (4) zugeordnete Durchführung (8) für das Anschlusselement (4) aufweist, wobei die Leiterplatte (3) mit der Antriebsvorrichtung (1) über das wenigstens eine Anschlusselement (4) von einer Kontaktierungsseite (10), die Kontaktierungsseite (10) der Antriebsvorrichtung (1) abgewandt ist, dadurch kontaktiert wird, dass das wenigstens eine Anschlusselement (4) durch die wenigstens eine Öffnung (8) der Leiterplatte (3) geführt wird, wobei die Kontaktierung der Leiterplatte (3) durch das wenigstens eine Anschlusselement (4) über wenigstens ein Umlenkmittel (5, 6) erfolgt, das auf der Kontaktierungsseite (10) der Leiterplatte (3) in der Steuereinheit (2) angeordnet ist, wobei das Umlenkmittel (5,6) einerseits mit der Leiterplatte (3) von der Kontaktierungsseite (10) her kontaktiert wird sowie andererseits mit dem Anschlusselement (4) der Antriebsvorrichtung (1) kontaktiert wird, **dadurch gekennzeichnet, dass** an einer Unterseite (13) eines Gehäuses (14) der Steuereinheit (2) wenigstens eine Aufnahme (7,15) für das wenigstens eine Umlenkmittel (5,6) ausgebildet wird, so dass das Umlenkmittel (5,6) in der Unterseite (13) des Gehäuses (14) gelagert und/oder gestützt wird.

10. Verfahren zur Herstellung nach Anspruch 9, dass das Führen des wenigstens einen Anschlusselements (4) durch die wenigstens eine Öffnung (8) der Leiterplatte (3) durch aufeinander Zuführen (603) der Antriebsvorrichtung (1) auf die Steuereinheit (2) erfolgt.

11. Verfahren zur Herstellung nach Anspruch 9 oder 10, **dadurch gekennzeichnet, dass** das wenigstens eine Anschlusselement (4) zusätzlich durch wenigstens eine Öffnung (9) in einem Gehäuse der Steuereinheit (2) eingeführt wird, wobei insbesondere die Öffnung (9) in einer Oberseite eines Gehäuses (14) vorgesehen ist, welche auf eine Unterseite (13) aufgesetzt (602) ist.

12. Verfahren zur Herstellung nach Anspruch 11, **dadurch gekennzeichnet, dass** die Leiterplatte (3) in der Unterseite (13) des Gehäuses (14) aufgenommen ist.

## Claims

1. Control unit (2) for actuating a drive apparatus (1),
- the control unit (2) having a printed circuit board (3) which is to be contacted with at least one connector element (4) of the drive apparatus (1),
- the printed circuit board (3) having at least one leadthrough (8) for the at least one connector element (4),
and it being possible for the printed circuit board (3) to be contacted from a contacting side (10) via the at least one connector element (4) to the drive apparatus (1), the contacting side (10) facing away from the drive apparatus (1), and the control unit (2) having at least one deflection means (5, 6) which is arranged on the contacting side (10) of the printed circuit board (3) in the control unit (2), it being possible for the deflection means (5, 6) to be contacted firstly with the printed circuit board (3) from the contacting side (10) and secondly with the at least one connector element (4) of the drive apparatus (1), **characterized in that** an underside (13) of a housing (14) of the control unit (2) has at least one receptacle (7, 15) for the at least one deflection means (5, 6), with the result that the deflection means (5, 6) is mounted and/or supported in the underside (13) of the housing (14).

2. Control unit (2) according to Claim 1, **characterized in that** the at least one leadthrough (8) is designed in such a way that the at least one connector element (4) can be guided from a mounting side (11) of the printed circuit board (3) through the at least one leadthrough (8) to the contacting side (10), the mounting side (11) of the printed circuit board (3) facing the drive apparatus (1), in particular.

3. Control unit (2) according to either of the preceding claims, the at least one deflection means (5, 6) having a contacting region (6a) for contacting the at least one connector element (4), the at least one receptacle (15, 7) having a contacting receptacle (7), into which the contacting region (6a) is received.

4. Control unit according to Claim 3, **characterized in that** the at least one connector element (4) can be received at least partially into the contacting receptacle (7).

5. Control unit according to Claim 4, **characterized in that** the contacting of the contacting region (6a) of the at least one deflection means (5, 6) can be established with the at least one connector element (4) in the contacting receptacle (7).

6. Control unit according to Claim 5, **characterized in that** the contacting can be established by pressing the at least one connector element (4) onto the contacting region (6a) in the contacting receptacle (7).

7. Control unit (2) according to one of the preceding claims, **characterized in that** the at least one connector element (4) to be contacted can be guided through a housing opening (9), assigned in each case to the at least one connector element (4), of a housing (14) of the control unit (2), in particular through a housing opening (9) which faces a mounting side (11) of the printed circuit board (3).

8. Motor unit (100) with a drive apparatus (1) and a control unit (2) according to one of the preceding claims, the drive apparatus (1) having at least one connector element (4) which is contacted with a printed circuit board (3) of the control unit (2) according to one of the preceding claims.

9. Method for producing a motor unit (100) which comprises a control unit (2) and a drive apparatus (1), the control unit (2) having a printed circuit board (3) which is to be contacted with at least one connector element (4) of the drive apparatus (1), and the printed circuit board (3) having at least one leadthrough (8), assigned to the at least one connector element (4), for the connector element (4), the printed circuit board (3) being contacted with the drive apparatus (1) via the at least one connector element (4) from a contacting side (10) which faces away from the contacting side (10) of the drive apparatus (1), by virtue of the fact that the at least one connector element (4) is guided through the at least one opening (8) of the printed circuit board (3), the contacting of the printed circuit board (3) taking place by way of the at least one connector element (4) via at least one deflection means (5, 6) which is arranged on the contacting side (10) of the printed circuit board (3) in the control unit (2), the deflection means (5, 6) being contacted firstly with the printed circuit board (3) from the contacting side (10) and being contacted secondly with the connector element (4) of the drive apparatus (1), **characterized in that** at least one receptacle (7, 15) for the at least one deflection means (5, 6) is configured on an underside (13) of a housing (14) of the control unit (2), with the result that the deflection means (5, 6) is mounted and/or supported in the underside (13) of the housing (14).

10. Method for production according to Claim 9, **characterized in that** the guidance of the at least one connector element (4) through the at least one opening (8) of the printed circuit board (3) takes place by feeding (603) the drive apparatus (1) onto the control unit (2) .

11. Method for production according to Claim 9 or 10, **characterized in that** the at least one connector element (4) is additionally introduced through at least one opening (9) in a housing of the control unit (2), the opening (9) being provided, in particular, in an upper side of a housing (14) which is placed (602) onto an underside (13).

12. Method for production according to Claim 11, **characterized in that** the printed circuit board (3) is received in the underside (13) of the housing (14).

## Revendications

1. Unité de commande (2) pour la commande d'un dispositif d'entraînement (1),
- l'unité de commande (2) présentant une carte de circuit imprimé (3) à mettre en contact avec au moins un élément de raccordement (4) du dispositif d'entraînement (1),
- la carte de circuit imprimé (3) présentant au moins un passage (8) pour l'au moins un élément de raccordement (4),
et la carte de circuit imprimé (3) pouvant être mise en contact avec le dispositif d'entraînement (1) depuis un côté de contact (10) par l'intermédiaire de l'au moins un élément de raccordement (4), le côté de contact (10) étant détourné du dispositif d'entraînement (1), et l'unité de commande (2) présentant au moins un moyen de déviation (5, 6), qui est agencé sur le côté de contact (10) de la carte de circuit imprimé (3) dans l'unité de commande (2), le moyen de déviation (5, 6) pouvant être mis en contact d'une part avec la carte de circuit imprimé (3) depuis le côté de contact (10) et d'autre part avec l'au moins un élément de raccordement (4) du dispositif d'entraînement (1), **caractérisée en ce qu'**un côté inférieur (13) d'un boîtier (14) de l'unité de commande (2) présente au moins un logement (7, 15) pour l'au moins un moyen de déviation (5, 6), de telle sorte que le moyen de déviation (5, 6) est monté et/ou soutenu dans le côté inférieur (13) du boîtier (14).

2. Unité de commande (2) selon la revendication 1, **caractérisée en ce que** l'au moins un passage (8) est conçu de telle sorte que l'au moins un élément de raccordement (4) peut être passé depuis un côté de montage (11) de la carte de circuit imprimé (3) à travers l'au moins un passage (8) vers le côté de contact (10), le côté de montage (11) de la carte de circuit imprimé (3) étant notamment tourné vers le dispositif d'entraînement (1).

3. Unité de commande (2) selon l'une quelconque des revendications précédentes, l'au moins un moyen de déviation (5, 6) présentant une zone de contact (6a) pour le contact de l'au moins un élément de raccordement (4), l'au moins un logement (15, 7) présentant un logement de contact (7) dans lequel est logée la zone de contact (6a) .

4. Unité de commande selon la revendication 3, **caractérisée en ce que** l'au moins un élément de raccordement (4) peut être logé au moins partiellement dans le logement de contact (7).

5. Unité de commande selon la revendication 4, **caractérisée en ce que** le contact de la zone de contact (6a) de l'au moins un moyen de déviation (5, 6) avec l'au moins un élément de raccordement (4) peut être établi dans le logement de contact (7).

6. Unité de commande selon la revendication 5, **caractérisée en ce que** le contact peut être établi en pressant l'au moins un élément de raccordement (4) sur la zone de contact (6a) dans le logement de contact (7).

7. Unité de commande (2) selon l'une quelconque des revendications précédentes, **caractérisée en ce que** l'au moins un élément de raccordement (4) à mettre en contact peut être acheminé à travers une ouverture de boîtier (9) d'un boîtier (14) de l'unité de commande (2) associée respectivement à l'au moins un élément de raccordement (4), notamment à travers une ouverture de boîtier (9) qui est tournée vers un côté de montage (11) de la carte de circuit imprimé (3).

8. Unité de moteur (100) comprenant un dispositif d'entraînement (1) et une unité de commande (2) selon l'une quelconque des revendications précédentes, le dispositif d'entraînement (1) présentant au moins un élément de raccordement (4), qui est mis en contact avec une carte de circuit imprimé (3) de l'unité de commande (2) selon l'une quelconque des revendications précédentes.

9. Procédé de fabrication d'une unité de moteur (100) qui comprend une unité de commande (2) et un dispositif d'entraînement (1), l'unité de commande (2) présentant une carte de circuit imprimé (3) à mettre en contact avec au moins un élément de raccordement (4) du dispositif d'entraînement (1), et la carte de circuit imprimé (3) présentant au moins un passage (8) pour l'élément de raccordement (4) associé à l'au moins un élément de raccordement (4), la carte de circuit imprimé (3) étant mise en contact avec le dispositif d'entraînement (1) par l'intermédiaire de l'au moins un élément de raccordement (4) depuis un côté de contact (10), le côté de contact (10) étant détourné du dispositif d'entraînement (1), de telle sorte que l'au moins un élément de raccordement (4) est acheminé à travers l'au moins une ouverture (8) de la carte de circuit imprimé (3), le contact de la carte de circuit imprimé (3) par l'au moins un élément de raccordement (4) s'effectuant par l'intermédiaire d'au moins un moyen de déviation (5, 6) qui est agencé sur le côté de contact (10) de la carte de circuit imprimé (3) dans l'unité de commande (2), le moyen de déviation (5, 6) étant d'une part mis en contact avec la carte de circuit imprimé (3) depuis le côté de contact (10) et d'autre part mis en contact avec l'élément de raccordement (4) du dispositif d'entraînement (1), **caractérisé en ce qu'**au moins un logement (7, 15) pour l'au moins un moyen de déviation (5, 6) est réalisé sur un côté inférieur (13) d'un boîtier (14) de l'unité de commande (2), de telle sorte que le moyen de déviation (5, 6) est monté et/ou soutenu dans le côté inférieur (13) du boîtier (14).

10. Procédé de fabrication selon la revendication 9, **caractérisé en ce que** l'acheminement de l'au moins un élément de raccordement (4) à travers l'au moins une ouverture (8) de la carte de circuit imprimé (3) est effectué par amenée (603) du dispositif d'entraînement (1) vers l'unité de commande (2).

11. Procédé de fabrication selon la revendication 9 ou 10, **caractérisé en ce que** l'au moins un élément de raccordement (4) est en outre introduit par au moins une ouverture (9) dans un boîtier de l'unité de commande (2), l'ouverture (9) étant notamment prévue dans un côté supérieur d'un boîtier (14) qui est placé (602) sur un côté inférieur (13).

12. Procédé de fabrication selon la revendication 11, **caractérisé en ce que** la carte de circuit imprimé (3) est logée dans le côté inférieur (13) du boîtier (14).
